# EUROPEAN PATENT SPECIFICATION

(11) **EP 3 131 121 B1**
(45) Date of publication and mention of the grant of the patent: **09.05.2018**
(21) Application number: 15180829.2
(22) Date of filing: 12.08.2015
(51) Int. Cl.: H01L 29/417, G01N 27/414, H01L 29/423, H01L 29/43, H01L 29/778, H01L 29/16, H01L 29/40, H01L 21/336, H01L 21/20

(54) **METHOD FOR MAKING A GRAPHENE-BASED FIELD-EFFECT APPARATUS**
VERFAHREN ZUM HERSTELLEN EINER AUF GRAPHEN BASIERDENDEN FELDEFFEKTVORRICHTUNG
PROCÉDÉ DE FABRICATION D'UN APPAREIL À EFFET DE CHAMP À BASE DE GRAPHÈNE

(43) Date of publication of application: 15.02.2017
(73) Proprietor: Provenance Asset Group LLC, Essex, CT 06426 (US)
(72) Inventor: Robinson, Adam, Cambridge, CB23 7PR (GB); Cotton, Darryl, Cambridge, PE27 5JX (GB); Bessonov, Alexander, Cambridge, CB1 3HR (GB); White, Richard, Huntingdon, PE28 9DY (GB); Liu, Yinglin, Cambridge, CB1 3SA (GB)
(74) Representative: Potter Clarkson LLP

(56) References cited:
- EP-A2- 2 620 982
- WO-A1-2014/025615
- WO-A1-2015/001286
- WO-A2-2007/094824
- US-A1- 2011 114 918
- US-A1- 2013 161 587
- US-A1- 2014 077 161
- US-A1- 2014 260 547

## Description

### Technical Field

The present disclosure relates particularly to a method of manufacturing a field-effect device. Certain embodiments specifically concern a method of making a field-effect apparatus which results in less contamination in the end product than prior art methods. This reduction in contamination can provide an increase in charge carrier mobility and a reduction in contact resistance. Certain aspects/embodiments may relate to sensing (e.g. biosensing, optical sensing, deformation sensing, etc) for healthcare, automotive or wearable applications. Other aspects/embodiments may relate to a method of manufacturing field-effect transistors suitable for portable electronic devices, in particular, so-called hand-portable electronic devices which may be hand-held in use (although they may be placed in a cradle in use). Such hand-portable electronic devices include so-called Personal Digital Assistants (PDAs) and tablet PCs.

The portable electronic devices/apparatus according to one or more disclosed examples may provide one or more audio/text/video communication functions (e.g. tele-communication, video-communication, and/or text transmission, Short Message Service (SMS)/ Multimedia Message Service (MMS)/emailing functions, interactive/non-interactive viewing functions (e.g. web-browsing, navigation, TV/program viewing functions), music recording/playing functions (e.g. MP3 or other format and/or (FM/AM) radio broadcast recording/playing), downloading/sending of data functions, image capture function (e.g. using a (e.g. in-built) digital camera), and gaming functions.

### Background

Research is currently being done to develop new field-effect devices with improved physical and electrical properties for use in a variety of applications.

US2013/0161587A1 describes a araohene device and a corresponding method, which includes a channel layer including graphene, a first electrode and second electrode on a first region and second region of the channel layer, respectively, and a capping layer covering the channel layer and the first and second electrodes. A region of the channel layer between the first and second electrodes is exposed by an opening in the capping layer. A gate insulating layer may be on the capping layer to cover the region of the channel layer, and a gate may be on the gate insulating layer. In particular, in the device disclosed here the source and drain electrodes are made from the catalyst material only and are located on a single side of the channel layer WO2007/094824A2 described methods for fabricating thin film electronic devices with both frontside and backside processing capabilities. Using these methods, high temperature processing steps may be carried out during both frontside and backside processing. The methods are suitable for fabricating back-gate and double-gate field effect transistors, double-sided bipolar transistors and 3D integrated circuits.

EP2620982A2 describes a method of manufacturing a graphene device which includes forming a device portion including a graphene layer (GP1) on a first substrate (SUB1); attaching a second substrate (SUB2) on the device portion of the first substrate; and removing the first substrate. The removal of the first substrate may include etching a sacrificial layer between the first substrate and the graphene layer. After removing the first substrate, a third substrate may be attached on the device portion. After attaching the third substrate, the second substrate may be removed.

WO2014/025615A describes a method for making thin films from layered materials and band gap devices formed therefrom. One aspect provides a method for fabricating one or more graphene based nanostructures. The method comprises depositing a catalytic material onto a substrate thereby forming a catalytic material layer on the substrate. The method further comprises nanopatterning the catalytic material layer thereby forming a nanotemplate. Still, the method further comprises depositing graphene onto the nanotemplate thereby forming the one or more graphene based nanostructures. US2011/0114918A1 describes a semiconductor-on-insulator structure and a method of forming the silicon-on-insulator structure including an integrated graphene layer. In an example, the method comprises processing a silicon material to form a buried oxide layer within the silicon material, a silicon substrate below the buried oxide, and a silicon-on-insulator layer on the buried oxide. A graphene layer is transferred onto the silicon-on-insulator layer. Source and drain regions are formed in the silicon-on-insulator layer, and a gate is formed above the graphene. In one example, the processing includes growing a respective oxide layer on each of first and second silicon sections, and joining these silicon sections together via the oxide layers to form the silicon material. The processing, in an example, further includes removing a portion of the first silicon section, leaving a residual silicon layer on the bonded oxide, and the graphene layer is positioned on this residual silicon layer.

US2014/0077161A1 describes a graphene transistor which includes: (1) a substrate; (2) a source electrode disposed on the substrate; (3) a drain electrode disposed on the substrate; (4) a graphene channel disposed on the substrate and extending between the source electrode and the drain electrode; and (5) a top gate disposed on the graphene channel and including a nanostructure. WO2015/001286A1 describes a sensor (1) formed of a graphene or silicon based nanostructure (10) having a flow path (21) which may be a channel or nanowire. The flow path is functionalised to attract certain molecules. The flow path has contacts (22) at either and the loading of the functionalised flow path alters the charge on that path and gives a measurement of the molecules. The sensor can provide a particularly sensitive device which can monitor a number of biomolecules in real-time, and in particular molecules associated with stress.

US2014/0260547A1 describes a graphene sensor and method for selective sensing of vapors, gases and biological agents. The graphene sensor can include a substrate; a dielectric substrate on an upper layer of the substrate; a layer of graphene on an upper layer of the dielectric substrate; and a source and drain contact on an upper surface of the layer of graphene. The method for detection of vapors, gases and biological objects with low frequency input as a sensing parameter can include exposing a graphene device to at least one vapor, gas, and/or biological object, the graphene device comprising: a substrate; a dielectric substrate on an upper layer of the substrate, a layer of graphene on an upper layer of the dielectric substrate, and a source and drain contact on an upper surface of the layer of graphene; and measuring a change in a noise spectra of the graphene device.

### Summary

The present invention comprises a method as defined in the claims, as well as a computer program configured to perform such a method. The method may comprise:
selectively depositing a further layer of dielectric material over the etched channel member; and
depositing the layer of conductive material onto the further layer of dielectric material such that the layer of conductive material is separated from the channel member by the further layer of dielectric material, the layer of conductive material forming a gate electrode configured to enable the flow of electrical current through the channel member to be varied by a voltage applied to the gate electrode.

The polymeric material may be configured to form a supporting substrate that is one or more of substantially reversibly deformable, substantially reversibly stretchable, substantially reversibly flexible and substantially reversibly compressible.
The layer of channel material may be grown using chemical vapour deposition.
The layer of channel material may comprise one or more of graphene, a two-dimensional chalcogenide, MoS₂, WS₂, MoSe₂, WSe₂ and WTe₂.

One or more of the layers of catalyst and conductive material may comprise at least one of a metal, an alloy, gold, silver, aluminium, copper, nickel, platinum, germanium and indium tin oxide.
The layer of polymeric material may comprise one or more of PI-2545, PI-2610, PI-2525, polyimide, polyethylene naphthalate and polyethylene terephthalate.
The layer(s) of dielectric material may comprise one or more of Si₃N₄, Al₂O₃, hBN, SiO₂ and HfO₂.

The layer of release material may comprise one or more of a refractory metal, a ceramic, SiO, SiO₂, Mo, W, Al₂O₃ and Si₃N₄.
The carrier wafer may comprise one or more of silicon, quartz and sapphire.

One or more of the source, drain and gate electrodes of the apparatus may be at least partially embedded within the polymeric material. An apparatus made using the method of the present invention may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a sensor, a photodetector, a field-effect transistor, and a module for one or more of the same.
The steps of any method disclosed herein do not have to be performed in the exact order disclosed, unless explicitly stated or understood by the skilled person.
Throughout the present specification, descriptors relating to relative orientation and position, such as "top", "bottom", "upper", "lower", "above" and "below", as well as any adjective and adverb derivatives thereof, are used in the sense of the orientation of the apparatus as presented in the drawings. However, such descriptors are not intended to be in any way limiting to an intended use of the described or claimed invention.

Corresponding computer programs for implementing the steps of the method of the invention are also within the present disclosure and are encompassed by one or more of the described example embodiments.
One or more of the computer programs may, when run on a computer, cause the computer to configure any apparatus, including a circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.
One or more of the computer programs may be provided on a computer readable medium, which may be a physical computer readable medium such as a disc or a memory device, or may be embodied as a transient signal. Such a transient signal may be a network download, including an internet download.
The present disclosure includes one or more corresponding aspects, example embodiments or features in isolation or in various combinations whether or not specifically stated (including claimed) in that combination or in isolation. Corresponding means for performing one or more of the discussed functions are also within the present disclosure.
The above summary is intended to be merely exemplary and non-limiting.

### Brief Description of the Figures

A description is now given, by way of example only, with reference to the accompanying drawings, in which:-
Figure 1 shows a conventional field-effect transistor (cross-section);
Figures 2a-d show one method of forming a field-effect apparatus (cross-section);
Figures 3a-f show another method of forming a field-effect apparatus (cross-section);
Figures 4a-c show various examples of a field-effect apparatus comprising a plurality of gated graphene channels (plan view);
Figures 5a-f show the method of forming a field-effect apparatus according to the invention (cross-section);
Figures 6a-c show a method of preventing contact between the gate electrode and channel member (cross-section);
Figures 7a-e show another method of forming a field-effect apparatus (cross-section);
Figure 8 shows one example of an apparatus described herein (schematic);
Figure 9 shows the main steps of a method described herein (flow chart);
Figure 10 shows a computer-readable medium comprising a computer program configured to perform, control or enable a method described herein (schematic); and Figures 11a-f show another method of forming a field-effect apparatus (cross-section).

### Description of Specific Examples, Aspects and Embodiments

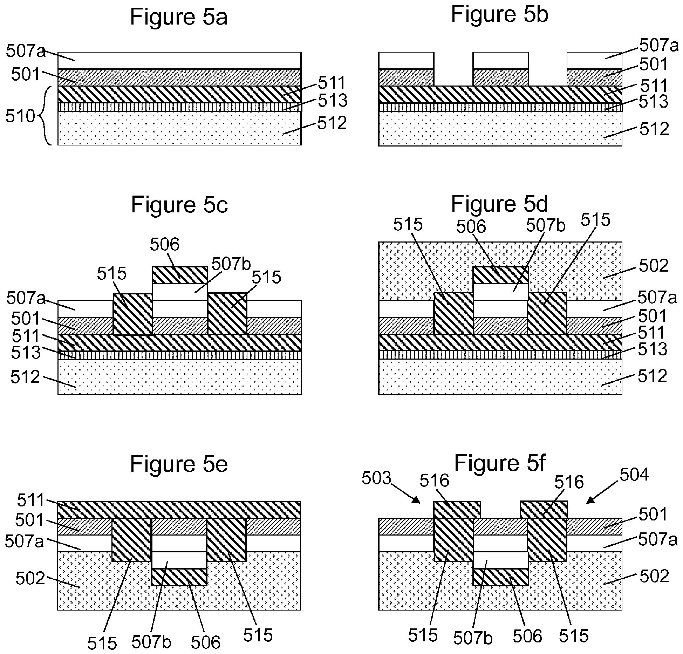

The invention concerns a method of manufacturing field-effect transistors (FETs) and will be discussed in detail with respect to Figure 5. Furthermore, examples, as well as possible further method steps are discussed below. A FET is a type of transistor in which an electrical current is passed through a channel, the conductance (or conductivity) of which can be controlled by a transverse electric field.

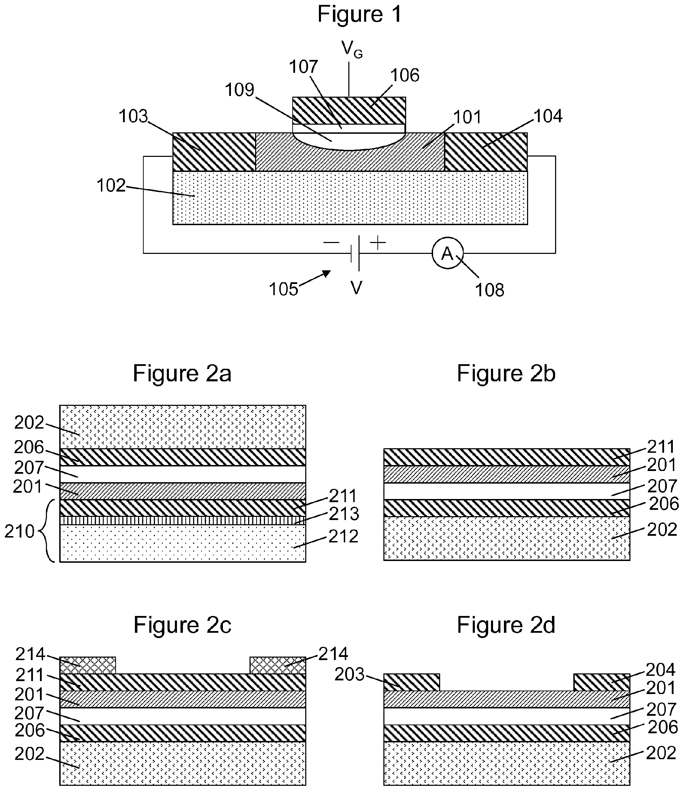

Figure 1 shows a conventional FET in cross-section. As shown in this figure, a semiconductor channel 101 (such as p-type silicon) is supported on a substrate 102 and connected to metal source 103 and drain 104 electrodes. A current enters and exits the channel via the source 103 and drain 104 electrodes, respectively, by applying a potential difference (V) 105 across the channel 101. The conductance of the channel 101 between the source 103 and drain 104 electrodes is switched on and off by a third electrode (the gate electrode 106) capacitively coupled through a thin dielectric layer 107. The conductance may be determined by measuring the current through the channel 101 (using an ammeter 108, for example) and dividing by the potential difference (V) 105. With p-type silicon (or another p-type semiconductor), application of a positive gate voltage (V_{G}) depletes the charge carriers (creating a depletion region 109 in the channel 101) and reduces the conductance, whilst applying a negative gate voltage (V_{G}) leads to an accumulation of charge carriers (creating a conductive region) and an increase in conductance.

Two factors which are important in defining the performance of FETs are the mobility of the charge carriers through the channel, and the contact resistance of the source and drain electrodes with the channel. It has been found, however, that the mobility and contact resistance are adversely affected by contamination at the surface of the channel where it can produce charge concentrations, scattering, locations for trapped water, and can inhibit physical and electrical contact. Contamination of the channel surface tends to increase with the number of processing steps performed on top of the channel (especially photolithography) and the transfer of the channel material from one substrate to another.

There will now be described a number of methods of forming a field-effect apparatus that may help to reduce the amount of contamination at the channel surface.

Figures 2a-d illustrate one method of forming a field-effect apparatus, shown as a series of cross-sectional process steps. First, a layer of channel material 201 is grown (e.g. via chemical vapour deposition) on a growth wafer 210 to form a channel member. The growth wafer 210 comprises a layer of catalyst material 211 separated from a carrier wafer 212 by a layer of release material 213, the catalyst material 211 serving as a seed layer for growing the layer of channel material 201. Respective layers of dielectric 207 and conductive 206 material are then deposited on the channel member 201 such that the layer of conductive material 206 is separated from the channel member 201 by the layer of dielectric material 207 to form a gate electrode. The layer of dielectric material 207 also acts as a barrier layer to protect the channel member 201 from water in humid environments or solvents (which can result in p-type channel FETs requiring large gate voltage biases to reach their Dirac points). The layer of dielectric material 207 may be deposited using atomic layer deposition, and the layer of conductive material 206 may be deposited by evaporation or sputtering. After deposition of the layers of dielectric 207 and conductive 206 material, a layer of polymeric material 202 is deposited over the channel member 201 to form a supporting substrate for the layers of catalyst 211 and channel material 201 (Figure 2a). This may be performed via spin coating, bar coating or spray coating a liquid polymer and curing to cross-link, or by hot embossing a polymer foil (i.e. heating above the glass transition temperature and imprinting).

The layer of release material 213 is then etched (e.g. wet chemical etching using hydrofluoric acid if etching silicon oxide) to remove the release material 213 and carrier wafer 212, and the stack is turned upside down (e.g. using the polymeric supporting substrate 202 for handling) so that the layer of polymeric material 202 is at the bottom of the stack (Figure 2b). A photoresist mask 214 is then formed on top of the layer of catalyst material 211 to allow corresponding patterning of the catalyst material 211 (Figure 2c). The mask 214 may be formed by selectively exposing the photoresist to incident electromagnetic radiation and developing the exposed regions to remove the unwanted photoresist. The layer of catalyst material 211 is then etched through the photoresist mask 214 to form source 203 and drain 204 electrodes (Figure 2d).

This method addresses the above-mentioned contamination issue in a number of different ways. Firstly, by depositing the layer of polymeric material 202 on top of the stack and then removing the carrier wafer 212, there is no need to transfer the channel member 201 from the growth substrate 210 to the polymeric support substrate 202. Secondly, at no point in the process does the layer of channel material 201 come into contact with the photoresist 214. This is because the source 203 and drain 204 electrodes are formed by selectively etching the layer of catalyst material 211 through a resist mask 214 rather than by selectively depositing a layer of conductive material through the resist mask 214. Thirdly, since the source 203 and drain 204 electrodes are formed from the layer of catalyst material 211 on which the channel member 201 is grown, the source 203 and drain 204 electrodes are adhered more strongly to the channel member 201 than they would be if the electrodes 203, 204 had been deposited on top of a pre-grown channel member. The resulting apparatus therefore benefits from less contamination that existing field-effect devices which results in greater charge carrier mobility and lower contact resistance.

As mentioned with reference to Figure 1, the source 203 and drain 204 electrodes are configured to enable a flow of electrical current through the channel member 201, and the gate electrode 206 is configured to enable the flow of electrical current through the channel member 201 to be varied by a voltage applied to the gate electrode 206. In this example, the layers of dielectric 207 and conductive 206 material are deposited between the channel member 201 and supporting substrate 202 to form a back gate electrode 206. The back gate electrode 206 is formed as a continuous layer of conductive material which may facilitate control of the electrical current by generating electric fields which are able to interact with the full length of the channel member 201. It is, however, also possible to form a discrete back gate electrode by patterning the layer of conductive material 206 before deposition of the layer of polymeric material 202 (not shown).

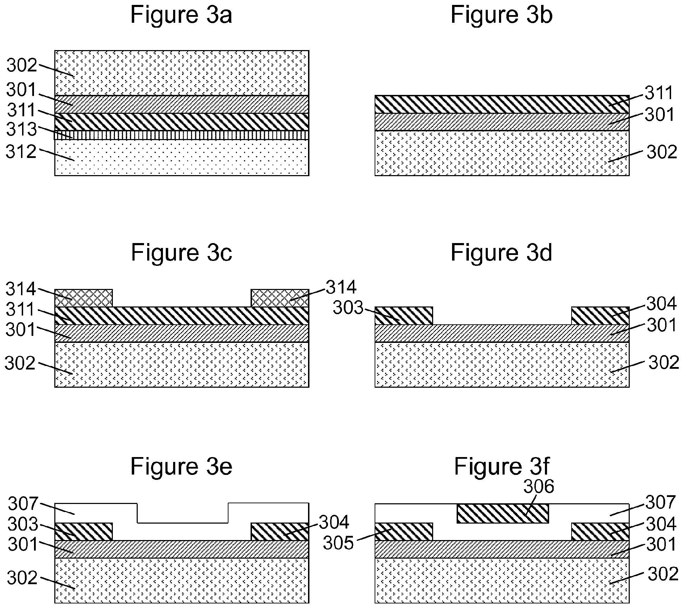

Figures 3a-e show another method of forming a field-effect apparatus (cross-section), this time comprising a top gate electrode 306. To achieve this, the layer of polymeric material 302 is deposited without the prior deposition of the dielectric and conductive layers (Figure 3a). The release material 313 and carrier wafer 312 are then removed as before and the stack is turned upside down (Figure 3b). Once the photoresist mask 314 has been formed on top of the layer of catalyst material 311 (Figure 3c), and the catalyst material 311 etched through the photoresist mask 314 to form source 303 and drain 304 electrodes (Figure 3d), a layer of dielectric material 307 can be deposited onto the channel 301 and source 303 and drain 304 electrodes to form a gate insulator (Figure 3e). A layer of conductive material 306 can then be deposited on top of the dielectric layer 307 to form a gate electrode (Figure 3f). In this example, the gate electrode 306 is localised to the channel region between the source 303 and drain 304 electrodes (e.g. by deposition through a mask), but a continuous layer covering the complete dielectric layer 307 could also be used for ease of fabrication without adversely affecting operation of the apparatus. With this method, therefore, the layers of dielectric 307 and conductive 306 material are deposited such that the supporting substrate 302 is separated from the layers of dielectric 307 and conductive 306 material by the channel member 301 to form a top gate electrode 306.

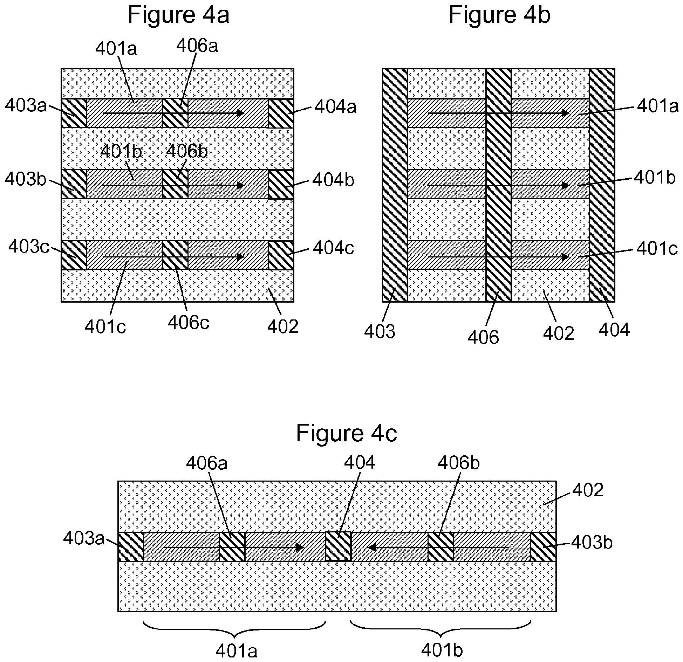

Figures 4a-c show various modifications of a field-effect apparatus (in plan-view) comprising a plurality of channel members 401a-c rather than a single channel member 401. This may form the basis of an electronic device which requires a high density of transistors or a sensor which is capable of detecting multiple stimuli, and can be fabricated by suitable patterning of the layer of channel material. For example, the layer of catalyst material may be pre-patterned before growing the layer of channel material to form the plurality of channel members 401a-c by selective growth. Alternatively, a continuous layer of channel material may be patterned after growth. The latter may be performed by depositing respective layers of dielectric material and photoresist on the layer of channel material such that the photoresist is separated from the layer of channel material by the layer of dielectric material, patterning the layer of photoresist, and etching the layers of channel and dielectric material through the patterned layer of photoresist.

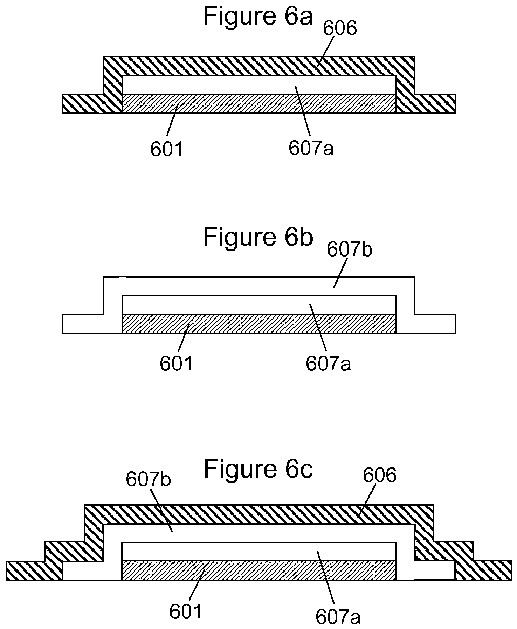

Here, the layer of dielectric material is used to prevent contact between the photoresist and the channel member 401 in order to reduce contamination at the surface of the channel member 401.
In the example shown in Figure 4a, the layers of catalyst and conductive material have been patterned to form a respective source electrode 403a-c, a respective drain electrode 404a-c and a respective gate electrode 406a-c for each channel member 401a-c. In some scenarios, however, it may be acceptable to use the same source 403, drain 404 or gate 406 electrode for multiple channel members 401a-c. Using the same electrode for multiple channel members 401a-c can simplify the fabrication process and device complexity and can also reduce material costs. In the example shown in Figure 4b, the layers of catalyst and conductive material have been patterned to form a common source electrode 403, a common drain electrode 404 and a common gate electrode 406 for the plurality of channel members 401a-c. In other examples, some of the source 403a-c, drain 404a-c and/or gate 406a-c electrodes may be associated with respective channel members and some may be associated with multiple channel members. Figure 4c is one such example, which comprises two channel members 401a,b formed from a single strip of channel material (in contrast to the examples of Figures 4a and 4b which comprise separate strips of channel material). In this example, the channel members 401a,b have their own source 403a,b and gate 406a,b electrodes but share a common drain electrode 404. As a result, the electrical currents flowing through each channel member 401a,b are in opposite directions (as indicated by the arrows). In the examples of Figures 4a and 4b, on the other hand, the current flow is in the same direction for each channel member 401a-c. The method of forming a field-effect apparatus according to the invention is illustrated in Figures 5a-f (in cross-section). First, a layer of channel material 501 is grown on a growth wafer 510 followed by the deposition of a layer of dielectric material 507a (Figure 5a). The layers of channel 501 and dielectric 507a material are then patterned (e.g. by selectively etching the channel 501 and dielectric 507a materials through a photoresist mask) to define the channel member (Figure 5b). A layer of conductive material is then deposited onto the layer of catalyst material 511 through the patterned layers of channel 501 and dielectric 507a material to form discrete regions of conductive material 515. After this, a further layer of dielectric material 507b is selectively deposited over the channel member 501 followed by a layer of conductive material to form a gate electrode 506 (Figure 5c). The further layer of dielectric material 507b helps to prevent contact between the gate electrode 506 and the underlying channel member 501 (described in more detail with reference to Figures 6a-c), as well as between the gate electrode 506 and the discrete regions of conductive material 515. It also allows the thickness of the dielectric material 507b forming the gate insulator to be independent of the thickness of the dielectric material 507a elsewhere.

A layer of polymeric material 502 is then deposited on top of the stack (Figure 5d), the release material 513 and carrier wafer 512 are removed as before and the stack is turned upside down (Figure 5e). As mentioned previously, the polymeric material 502 may be deposited as a liquid polymer and cured, or as a polymer foil and embossed. Either way, the layer of polymeric material 502 encapsulates the gate electrode 506 and exposed regions of conductive material 515. Finally, the layer of catalyst material 511 is patterned to form electrical contacts 516 overlying the channel member 501 and respective discrete regions of conductive material 515 (Figure 5f). In this way, the electrical contacts 516 and respective discrete regions of conductive material 515 together form source 503 and drain 504 electrodes.

If the process illustrated in Figures 5a-f is to be used to form a plurality of gated channel members, any channel material 501 which is not used to form the channel members may be removed to help prevent short circuits between adjacent channel members or their respective electrodes 503, 504.

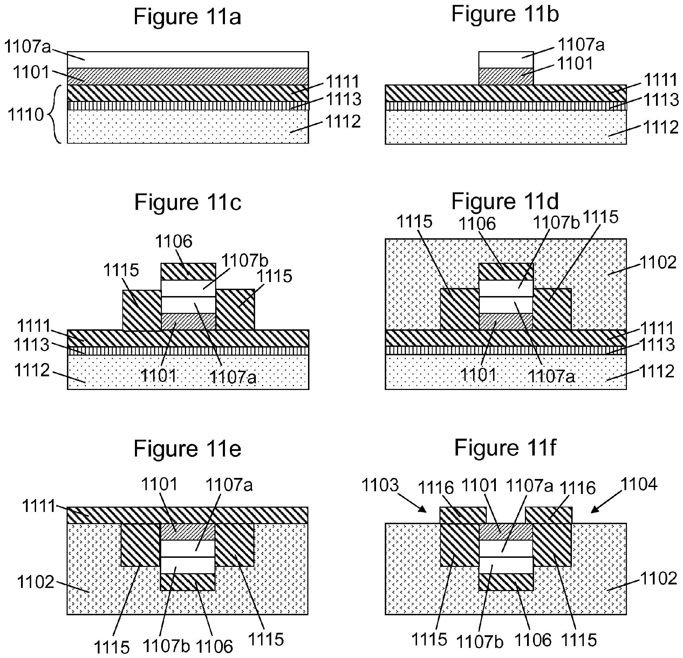

Figures 11a-f show a modified version of the process of Figures 5a-f in which the excess channel material 1101 is etched away before formation of the source 1103, drain 1104 and gate 1106 electrodes. As with the previous process, the layers of channel 1101 and dielectric 1107a material are patterned to define the channel member (e.g. by etching through a photoresist mask). This time, however, the layers of channel 1101 and dielectric 1107a material are patterned such that all material outside the channel region is removed by the etching step (Figure 11b). The further layer of dielectric material 1107b is then selectively deposited over the channel member (e.g. using a photoresist mask on top of the layer of catalyst material 1111) followed by the deposition of a layer of conductive material to form the gate electrode 1106. Once the mask is removed, a further mask (e.g. photoresist) can then be used to selectively deposit discrete regions of conductive material 1115 for the source 1103 and drain 1104 electrodes (Figure 11c). In some cases, the same layer of conductive material may be used for the source 1103, drain 1104 and gate 1106 electrodes. To achieve this, the mask used during deposition of the further layer of dielectric material 1107b is removed before selective deposition of the conductive material. The remaining steps of the process (e.g. Figures 11d-f) are the same as those described with reference to Figures 5d-f.

Figures 6a-c show how the further layer of dielectric material 507b is Figure 5c can help to prevent contact between the gate electrode 506 and the underlying channel member 501. These figures are cross-sectional views of the corresponding layers of Figure 5c perpendicular to the cross-section of Figure 5c (i.e. into the page). As illustrated in Figure 6a, deposition of the layer of conductive material 606 on top of the channel member 601 and layer of dielectric material 607a can result in contact between the conductive material 606 and the channel material 601 at the edges of the channel member which may create a short circuit. The reason for extending the layer of conductive material 606 down the edges of the channel member 601 is to enable connection of the gate electrode 606 to a power supply for provision of a gate voltage. By depositing a further layer of dielectric material 607b on top of the first layer of dielectric material 607a (Figure 6b), however, the edges of the channel member 601 can be insulated from the layer of subsequently deposited conductive material 606 (Figure 6c). In some cases, the further layer of dielectric material 607b may be deposited at the edges of the channel member 601 only so as not to increase the distance between the gate electrode 606 and the channel member 601.

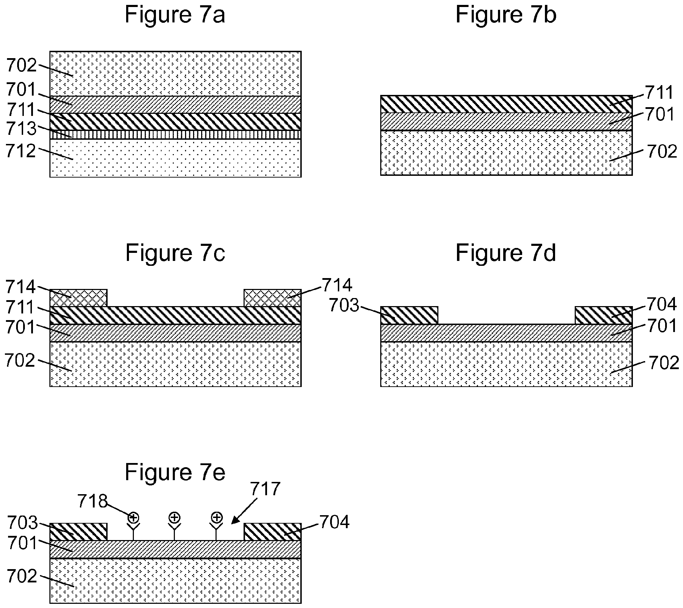

Figures 7a-e show a further method of forming a field-effect apparatus. As can be seen from these figures, steps 7a-d are identical to steps 3a-d of the method described with reference to Figure 3. This time, however, instead of depositing respective layers of dielectric and conductive material onto the channel member 701, the method comprises depositing a layer of sensor material 717 (e.g. by spin casting, inkjet printing or stamping) configured to vary the flow of electrical current through the channel member 701 in response to an applied stimulus. The layer of sensor material 717 functionalises or activates the channel member 701 such that the applied stimulus is able to gate the channel member 701 instead of a gate electrode, thus enabling detection of the stimulus based on the variation in electrical current. In practice, the sensor material 717 may be configured to enable detection of any stimulus provided that the interaction of that stimulus with the sensor material 717 results in a change in electrical current through the channel member. For example, the sensor material 717 may comprise one or more of a quantum dot material for sensing electromagnetic radiation, a pyroelectric material for sensing temperature, a piezoelectric material for sensing mechanical stress, a chemical binding agent for sensing a chemical species, and a biological receptor for sensing a biological species. In the example shown in Figure 7e, the layer of sensor material 717 comprises an antibody configured to bind to a charged species 718 in the surrounding environment such that the charged species 718 is in sufficient proximity to the channel member 701 to cause a variation in electrical current.

Although the applied stimulus gates the channel member instead of a gate electrode in this example, a bottom gate electrode could be used to tune the conductance/conductivity of the channel member 701. In this respect, it is also possible to incorporate the layer of sensor material 717 of Figure 7 into the methods of Figures 2 and 5.

A number of different materials may be used in the above-mentioned processes. One particular example involves the use of a graphene channel member grown on a silicon carrier wafer using copper as the catalyst material and silicon oxide as the release material. In this example, the dielectric material may comprise aluminium oxide, the conductive material may comprise copper, the polymeric material may comprise polyimide, and the sensor material may comprise PbS quantum dots. This example benefits from the high mobility of graphene, the quantum efficiency of PbS quantum dots and the mechanical resilience of polyimide, thus rendering it suitable for use as a reversibly deformable (e.g. flexible, stretchable and/or compressible) graphene field-effect transistor (GFET) photodetector.

The present methods and resulting field-effect apparatus are not limited to these specific materials. For example, the channel material may comprise one or more of graphene, a two-dimensional chalcogenide, MoS₂, WS₂, MoSe₂, WSe₂ and WTe₂; the catalyst and conductive materials may comprise one or more of a metal, an alloy, gold, silver, aluminium, copper, nickel, platinum, germanium and indium tin oxide (the catalyst material should be electrically conductive to enable its use as source and drain electrodes); the polymeric material may comprise one or more of HD Microsystems™ Pl-2545, Pl-2610 or Pl-2525, polyimide, polyethylene naphthalate and polyethylene terephthalate; the dielectric material may comprise one or more of Si₃N₄, Al₂O₃, hBN, SiO₂ and HfO₂; the release material may comprise one or more of a refractory metal, a ceramic, SiO, SiO₂, Mo, W, Al₂O₃ and Si₃N₄ (the release material should be resistant to the high temperatures that are possible during growth of the channel material, should not form compounds with the catalyst material and should have etch selectivity against the catalyst and polymeric materials); and the carrier wafer may comprise one or more of silicon, quartz and sapphire.

Also, as mentioned above, a number of different types of sensor material may be used depending on the specific stimuli being detected. These include, but are not limited to, one or more of: a quantum dot material (e.g. CdSe, CdS, PbSe, PbS, ZnO, ZnS, CZTS, Cu₂S, Bi₂S₃, Ag₂S, HgTe, CdSe, CdHgTe, InAs, InSb, Ge or CIS); a pyroelectric material (e.g. polyvinylidine fluoride, P(VDF-trifluoroethylene), lithium tantalate and gallium nitride); a piezoelectric material (e.g. polyvinylidene fluoride, lead zirconium titanate, barium titanate and zinc oxide); a chemical binding agent (e.g. an alkanethiol and an alkoxysilane); and a biological receptor (e.g. an antibody).

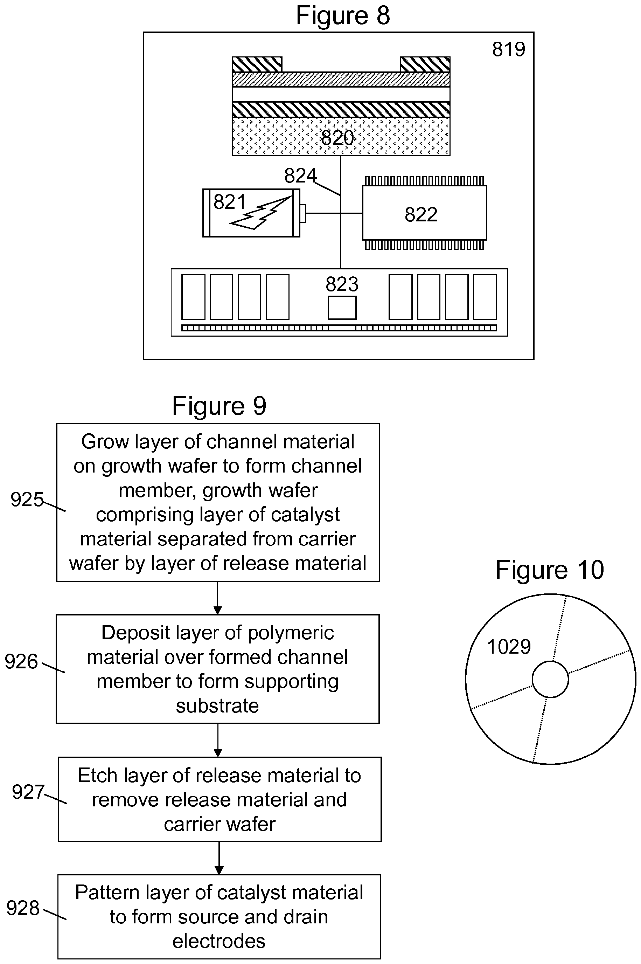

Figure 8 shows one example of an apparatus 819 at least partly formed using a method described herein. The apparatus 819 may be one or more of an electronic device, a portable electronic device, a portable telecommunications device, a mobile phone, a personal digital assistant, a tablet, a phablet, a desktop computer, a laptop computer, a server, a smartphone, a smartwatch, smart eyewear, a sensor, a photodetector, a field-effect transistor, and a module for one or more of the same. In the example shown, the apparatus 819 comprises the various components described previously (denoted collectively by reference numeral 820), a power source 821, a processor 822 and a storage medium 823, which are electrically connected to one another by a data bus 824.

The processor 822 is configured for general operation of the apparatus 819 by providing signalling to, and receiving signalling from, the other components to manage their operation. The storage medium 823 is configured to store computer code configured to perform, control or enable operation of the apparatus 819. The storage medium 823 may also be configured to store settings for the other components. The processor 822 may access the storage medium 823 to retrieve the component settings in order to manage the operation of the other components.

Under the control of the processor 822, the power source 821 is configured to apply a voltage between the source and drain electrodes to enable a flow of electrical current through the channel member, and apply a gate voltage to the gate electrode to cause a detectable change in the flow of electrical current. In this way, the components 820 may act as an electronic switch within the circuitry of the apparatus 819.
The processor 822 may be a microprocessor, including an Application Specific Integrated Circuit (ASIC). The storage medium 823 may be a temporary storage medium such as a volatile random access memory. On the other hand, the storage medium 823 may be a permanent storage medium 823 such as a hard disk drive, a flash memory, or a non-volatile random access memory. The power source 821 may comprise one or more of a primary battery, a secondary battery, a capacitor, a supercapacitor and a battery-capacitor hybrid.
Figure 9 shows schematically the main steps 925-928 of a method of making a field-effect apparatus. The method generally comprises: growing a layer of channel material on a growth wafer to form a channel member, the growth wafer comprising a layer of catalyst material separated from a carrier wafer by a layer of release material 925; depositing a layer of polymeric material over the formed channel member to form a supporting substrate 926; etching the layer of release material to remove the release material and carrier wafer 927; and patterning the layer of catalyst material to form source and drain electrodes 928.
Figure 10 illustrates schematically a computer/processor readable medium 1029 providing a computer program according to one embodiment. The computer program comprises computer code configured to perform at least the method steps defined in claim 1. Additionally the computer program may comprise computer code configured to apply a voltage between the source and drain electrodes to enable a flow of electrical current through the channel member; and apply a gate voltage to the gate electrode to cause a detectable change in the flow of electrical current.
In this example, the computer/processor readable medium 1029 is a disc such as a digital versatile disc (DVD) or a compact disc (CD). In other examples, the computer/processor readable medium 1029 may be any medium that has been programmed in such a way as to carry out the inventive method. The computer/processor readable medium 1029 may be a removable memory device such as a memory stick or memory card (SD, mini SD, micro SD or nano SD).

Other examples or embodiments depicted in the figures have been provided with reference numerals that correspond to similar features of earlier described examples or embodiments. For example, feature number 1 can also correspond to numbers 101, 201, 301 etc. These numbered features may appear in the figures but may not have been directly referred to within the description of these particular examples or These have still been provided in the figures to aid understanding of the further examples or embodiments, particularly in relation to the features of similar earlier described examples or embodiments. It will be appreciated to the skilled reader that any mentioned apparatus/device and/or other features of particular mentioned apparatus/device may be provided by apparatus arranged such that they become configured to carry out the desired operations only when enabled, e.g. switched on, or the like. In such cases, they may not necessarily have the appropriate software loaded into the active memory in the non-enabled (e.g. switched off state) and only load the appropriate software in the enabled (e.g. on state). The apparatus may comprise hardware circuitry and/or firmware. The apparatus may comprise software loaded onto memory. Such software/computer programs may be recorded on the same memory/processor/functional units and/or on one or more memories/processors/functional units.

In some cases, a particular mentioned apparatus/device may be pre-programmed with the appropriate software to carry out desired operations, and wherein the appropriate software can be enabled for use by a user downloading a "key", for example, to unlock/enable the software and its associated functionality. Advantages associated with such examples can include a reduced requirement to download data when further functionality is required for a device, and this can be useful in examples where a device is perceived to have sufficient capacity to store such pre-programmed software for functionality that may not be enabled by a user.

It will be appreciated that any mentioned apparatus/circuitry/elements/processor may have other functions in addition to the mentioned functions, and that these functions may be performed by the same apparatus/circuitry/elements/processor. One or more disclosed aspects may encompass the electronic distribution of associated computer programs and computer programs (which may be source/transport encoded) recorded on an appropriate carrier (e.g. memory, signal).
It will be appreciated that any "computer" described herein can comprise a collection of one or more individual processors/processing elements that may or may not be located on the same circuit board, or the same region/position of a circuit board or even the same device. In some cases one or more of any mentioned processors may be distributed over a plurality of devices. The same or different processor/processing elements may perform one or more functions described herein.
It will be appreciated that the term "signalling" may refer to one or more signals transmitted as a series of transmitted and/or received signals. The series of signals may comprise one, two, three, four or even more individual signal components or distinct signals to make up said signalling. Some or all of these individual signals may be transmitted/received simultaneously, in sequence, and/or such that they temporally overlap one another.
With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.
The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/embodiments may consist of any such individual feature or combination of features. In view of the foregoing description it will be evident to a person skilled in the art that as long as he works within the scope of the independent claim, various modifications may be made. The invention is defined by the independent claims, as well as the dependent claims. While there have been shown and described and pointed out fundamental novel features as applied to different embodiments thereof, it will be understood that as long as they stay within the scope of the claims, various changes in to the method of the invention may be made by those skilled in the art. Moreover, it should be recognized that structures and/or elements and/or method steps shown and/or described in connection with any disclosed form or embodiment may be incorporated in any other disclosed or described or suggested form or embodiment as a general matter of design choice.

## Claims

1. A method comprising:
growing a layer of channel material (501) on a growth wafer (510) to form a channel member (501), the growth wafer (510) comprising a layer of conductive catalyst material (511) separated from a carrier wafer (512) by a layer of release material (513), the conductive catalyst material (511) serving as a seed layer for growing the layer of channel material (501);
depositing respective layers of dielectric material (507a) and photoresist on the channel member (501) such that the photoresist is separated from the channel member (501) by the layer of dielectric material (507a);
patterning the layer of photoresist;
etching through the channel member (501) and layer of dielectric material (507a) through the patterned layer of photoresist;
depositing a layer of conductive material (515) onto the layer of conductive catalyst material (511) through the etched channel member (501) and layer of dielectric material (507a) to form discrete regions of conductive material (515);
depositing a layer of polymeric material (502) over the layer of dielectric material (507a) and discrete regions of conductive material (515) to form a supporting substrate (502);
etching the layer of release material (513) to remove the release material (513) and carrier wafer (512); and
patterning the layer of conductive catalyst material (511) to form electrical contacts (516) overlying the channel member (501) and respective discrete regions of conductive material (515), the electrical contacts (516) and respective discrete regions of conductive material (515) together forming source (503) and drain (504) electrodes configured to enable a flow of electrical current through the channel member (501).

2. The method of claim 1, wherein the method comprises:
selectively depositing a further layer of dielectric material (507b) over the etched channel member (501); and
depositing the layer of conductive material (506) onto the further layer of dielectric material (507b) such that the layer of conductive material (506) is separated from the channel member (501) by the further layer of dielectric material (507b), the layer of conductive material (506) forming a gate electrode (506) configured to enable the flow of electrical current through the channel member (501) to be varied by a voltage applied to the gate electrode (506).

3. A computer program comprising computer code configured to perform the method of any preceding claim.

## Patentansprüche

1. Verfahren, Folgendes umfassend:
Wachsenlassen einer Schicht von Kanalmaterial (501) auf einem Wachstumswafer (510), um ein Kanalelement (501) auszubilden, wobei der Wachstumswafer (510) eine Schicht leitfähigen Katalysatormaterials (511) umfasst, das von einem Trägerwafer (512) durch eine Schicht von Trennmaterial (513) getrennt ist, wobei das leitfähige Katalysatormaterial (511) als eine Saatschicht zum Wachsenlassen der Schicht von Kanalmaterial (501) dient;
Abscheiden jeweiliger Schichten von dielektrischem Material (507a) und von Fotolack auf dem Kanalelement (501), sodass der Fotolack von dem Kanalelement (501) durch die Schicht von dielektrischem Material (507a) getrennt ist;
Strukturieren der Schicht von Fotolack;
Ätzen durch das Kanalelement (501) und die Schicht von dielektrischem Material (507a) durch die strukturierte Schicht von Fotolack;
Abscheiden einer Schicht von leitfähigem Material (515) auf die Schicht von leitfähigem Katalysatormaterial (511) durch das geätzte Kanalelement (501) und die Schicht von dielektrischem Material (507a), um diskrete Bereiche von leitfähigem Material (515) auszubilden;
Abscheiden einer Schicht von polymerem Material (502) auf die Schicht von dielektrischem Material (507a) und die diskreten Bereiche von leitfähigem Material (515), um ein stützendes Substrat (502) auszubilden;
Ätzen der Schicht von Trennmaterial (513), um das Trennmaterial (513) und den Trägerwafer (512) zu entfernen; und
Strukturieren der Schicht von leitfähigem Katalysatormaterial (511), um elektrische Kontakte (516) auszubilden, die über dem Kanalelement (501) und jeweiligen diskreten Bereichen von leitfähigem Material (515) liegen, wobei die elektrischen Kontakte (516) und die jeweiligen diskreten Bereiche von leitfähigem Material (515) gemeinsam Source(503)- und Drain(504)-Elektroden ausbilden, die dazu ausgelegt sind, einen Fluss von elektrischem Strom durch das Kanalelement (501) zu ermöglichen.

2. Verfahren nach Anspruch 1, wobei das Verfahren Folgendes umfasst:
ausgewähltes Abscheiden einer weiteren Schicht von dielektrischem Material (507b) auf das geätzte Kanalelement (501); und
Abscheiden der Schicht von leitfähigem Material (506) auf die weitere Schicht von dielektrischem Material (507b), sodass die Schicht von leitfähigem Material (506) von dem Kanalelement (501) durch die weitere Schicht von dielektrischem Material (507b) getrennt ist, wobei die Schicht von leitfähigem Material (506) eine Gate-Elektrode (506) ausbildet, die ausgelegt ist zu ermöglichen, dass der Fluss von elektrischem Strom durch das Kanalelement (501) durch eine auf die Gate-Elektrode (506) aufgebrachte Spannung variiert wird.

3. Computerprogramm, umfassend Computercode, dazu ausgelegt, das Verfahren eines vorhergehenden Anspruchs auszuführen.

## Revendications

1. Procédé comprenant :
l'accroissement d'une couche de matériau de canal (501) sur une plaquette favorisant l'accroissement (510) pour former un élément de canal (501), la plaquette favorisant l'accroissement (510) comprenant une couche de matériau catalyseur conducteur (511) séparée d'une plaquette porteuse (512) par une couche de matériau de libération (513), le matériau catalyseur conducteur (511) servant de couche d'ensemencement pour accroître la couche de matériau de canal (501) ;
le dépôt de couches respectives de matériau diélectrique (507a) et d'une résine photosensible sur l'élément de canal (501) de telle sorte que la résine photosensible est séparée de l'élément de canal (501) par la couche de matériau diélectrique (507a) ;
l'application de motifs sur la couche de résine photosensible ;
la gravure sur l'élément de canal (501) et la couche de matériau diélectrique (507a) au moyen de la couche à motifs de résine photosensible ;
le dépôt d'une couche de matériau conducteur (515) sur la couche de matériau catalyseur conducteur (511) au moyen de l'élément de canal gravé (501) et de la couche de matériau diélectrique (507a) pour former des régions discrètes de matériau conducteur (515) ;
le dépôt d'une couche de matériau polymère (502) par-dessus la couche de matériau diélectrique (507a) et des régions discrètes du matériau conducteur (515) pour former un substrat de support (502) ;
la gravure de la couche de matériau de libération (513) pour éliminer le matériau de libération (513) et la plaquette porteuse (512) ; et
l'application de motifs sur la couche de matériau catalyseur conducteur (511) pour former des contacts électriques (516) recouvrant l'élément de canal (501) et des régions discrètes respectives de matériau conducteur (515), les contacts électriques (516) et les régions discrètes respectives de matériau conducteur (515) formant conjointement des électrodes source (503) et déversoir (504) configurées pour permettre un écoulement de courant électrique à travers l'élément de canal (501).

2. Procédé selon la revendication 1, dans lequel le procédé comprend :
le dépôt sélectif d'une couche supplémentaire de matériau diélectrique (507b) par-dessus l'élément de canal gravé (501) ; et
le dépôt de la couche de matériau conducteur (506) sur la couche supplémentaire de matériau diélectrique (507b) de telle sorte que la couche de matériau conducteur (506) est séparée de l'élément de canal (501) par la couche supplémentaire de matériau diélectrique (507b), la couche de matériau conducteur (506) formant une électrode grille (506) configurée pour permettre à l'écoulement de courant électrique à travers l'élément de canal (501) de varier par une tension appliquée sur l'électrode grille (506).

3. Programme informatique comprenant un code informatique configuré pour mener à bien le procédé de l'une quelconque des revendications précédentes.
